Europäisches Patentamt

(19) European Patent Office

Office européen des brevets

(11) EP 0 954 093 A1

## (12) EUROPEAN PATENT APPLICATION

(43) Date of publication:
03.11.1999 Bulletin 1999/44

(51) Int. Cl.⁶: $H03B\ 1/04$, $H03D\ 7/14$

(21) Application number: 99108277.7

(22) Date of filing: 27.04.1999

(84) Designated Contracting States:
AT BE CH CY DE DK ES FI FR GB GR IE IT LI LU
MC NL PT SE
Designated Extension States:
AL LT LV MK RO SI

(30) Priority: 29.04.1998 US 69889

(71) Applicant: Mitel, Inc.
San Jose, CA 95110 (US)

(72) Inventor:
Granger-Jones, Marcus R.
Scotts Valley, CA 95066 (US)

(74) Representative: Liesegang, Eva
Forrester & Boehmert,
Franz-Josef-Strasse 38
80801 München (DE)

## (54) Suppression of local oscillator second order harmonics

(57) A system and a method are provided for supplying oscillating signals having suppressed even order harmonic components. Such oscillating signals can be supplied over broad frequency bands including RF signals of between 10 kilohertz (10 kHz) and 100,000 megahertz (100,000 MHz). In particular, symmetric square wave signals are supplied which have essentially no D.C. or second order harmonic components. Such signals are used for frequency shifting purposes. Any undesired mixing products generated by any odd order harmonics typically will not overlap signals desired from frequency shifting operations, and thus can typically be filtered off. Moreover, some common mixer designs yield minimal noise when driven by square wave signals, particularly when driven by the supplied symmetric square wave signals.

FIG. 2A

Description

## BACKGROUND OF THE INVENTION

### Field of the Invention

The present invention pertains to local oscillation systems and methods, and more particularly, to suppression of even order harmonic components of an oscillating signal.

### Description of the Related Art

In the field of radio communications, signals are transmitted over a plurality of channels each comprising a carrier frequency $f_{CF}$ and frequency bands on one or both sides of the carrier frequency $f_{CF}$. To communicate a signal S of low frequency $f_S$ over a high frequency channel, the signal S can be mixed with a carrier signal CS at the carrier frequency $f_{CS}$ of the channel to generate a modulated signal MS. The modulated signal MS can then be transmitted over the channel to a receiver.

The receiver may downshift a received signal RS to obtain signal S by mixing the received signal RS with another oscillating signal CS2 at the same carrier frequency $f_{CF}$. Alternatively, the receiver may downshift the received signal RS to an intermediate frequency $f_{IF}$ band between the low and carrier frequencies by mixing the received signal RS with an oscillating signal (OCS) of frequency $f_{OCS} \cong (f_{CF} - f_{IF})$. This is frequently done to support filtration and or amplification processes in such intermediate frequency $f_{IF}$ band.

Such mixing operations typically yield both a desired signal DS and undesired mixing products. The undesired mixing products can be caused by interfering signals received from other transmission sources. For example, second harmonics of an interfering signal of frequency ½ $(f_{CS} + f_{OSC})$ may be mixed with a second harmonic of the oscillating signal OCS to yield an undesired mixing product of frequency $(f_{CS} + f_{OSC} - 2f_{OSC}) = f_{CS} - f_{OSC} = -f_{IF}$, which is in the frequency band of the desired signal DS. Such an interfering signal is commonly called a "half IF" signal. Once such distortion is frequency shifted in band with the desired signal DS, it cannot be removed by simple filtering processes, and may result in irreversible distortion to the desired signal DS. Further, the receiver will be desensitized by such in band distortion.

It is generally desirable for the receiver to suppress the undesired mixing products. Such suppression is a function of both the second harmonic content of the received signal RS, and the second harmonic content of the oscillating signal OSC. Suppressing second order harmonic components in the oscillating signal OSC suppresses undesired mixing products as well.

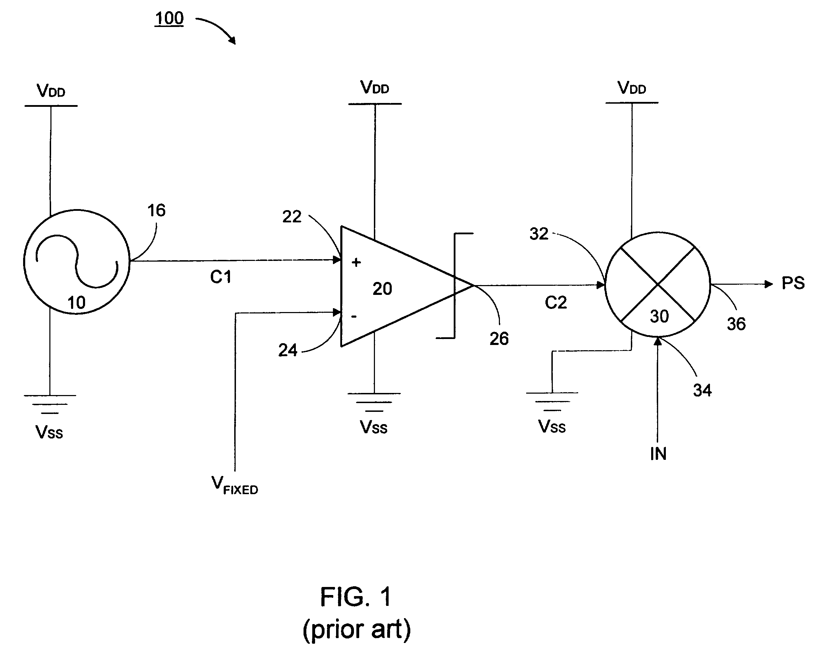

Referring now to Figure 1, there is shown a block diagram of a conventional circuit 100 for downshifting an input signal IN to obtain a desired signal DS. Conventional circuit 100 includes a local oscillator 10, differential amplifier 20, and mixer 30. The local oscillator supplies an oscillating signal C1 to input 22 of the differential amplifier 20, and a fixed voltage $V_{FIXED}$ is supplied to input 24 of the differential amplifier 20. The differential amplifier 20 amplifies the voltage differential $(C1 - V_{FIXED})$ between inputs 22, 24, and supplies this amplified voltage differential as output signal C2 at output 26. If the gain $\tau$ and slew rate $\gamma$ of the differential amplifier 20 are sufficiently high, the differential amplifier 20 will clip at minimum and maximum clipping voltages during operation. Consequently, if the fundamental frequency $f_{C1}$ of oscillating signal C1 is sufficiently low, the output signal C2 will be shaped roughly like a square wave of frequency $f_{C1}$. The mixer 30 then mixes the input signal IN with the output signal C2 to obtain the desired signal DS in the intermediate frequency $f_{IF}$ band and various undesired mixing products.

The conventional circuit 100 is limited. The output signal C2 typically includes amplified distortion and D.C. components of the oscillating signal C1. Particularly, even order harmonics of the oscillating signal C1 will be amplified by the differential amplifier 20, thus distorting the output signal C2. This typically causes deviation in the output signal C2 from fifty percent duty cycle. That is, the output signal C2 will not have even mark-to-space ratio, where the mark and space conditions respectively are the HIGH and LOW state durations of the output signal C2. The magnitude of such deviation is believed to depend on the amplitude of the even order components in output signal C2, and on the phase of the even order harmonics relative to the fundamental frequency of output signal C2.

Non-idealities of the differential amplifier 20 also supply distortion to the output signal C2. For example, due to imperfect component matching, the differential amplifier 20 typically has a random D.C. offset voltage of magnitude between 0 mV and about 5 mV. Such random D.C. offset voltage adds a substantial D.C. component to the output signal C2.

When output signal C2 is mixed with the input signal IN in the mixer 30, various undesired mixing products will be obtained. The P.C. and second order harmonic components of the output signal C2 can produce undesired mixing products in the intermediate frequency $f_{IF}$ band, for example, from a half IF interfering signal received with the input signal IN, or from other received signals which have been intermodulated into the intermediate frequency $f_{IF}$ band. This significantly, and usually irreversibly, distorts the desired signal DS.

There is thus a significant need for an improved system and method for generating oscillating signals of suitable quality for frequency-shifting applications. In addition, there is a need to substantially suppress the even order harmonics, particularly the D.C. and second order harmonics, of these oscillating signals. Further, there is a need for a system and method to yield symmetric square wave signals as output for superior mixing results in common mixer designs, such as the Gilbert Cell mixer. Moreover, a system and method should have a highly symmetric circuit design for improved operation at frequencies above about 800 MHz.

## SUMMARY OF THE INVENTION

The present invention comprises a system and method for supplying oscillating signals having suppressed even order harmonic components. Such oscillating signals can be supplied over broad frequency bands including RE signals of between 10 kilohertz (10 kHz) and 100,000 megahertz (100,000 MHz). These signals are believed to be highly beneficial as carrier signals for modulation, demodulation, and other frequency shifting applications. In particular, symmetric square wave signals are supplied which have essentially no direct current (D.C.) or second order harmonic components.

In accordance with one aspect of the present invention, a symmetric square wave signal is supplied using a differential amplifier having a single output, with the symmetric square wave signal being the voltage differential at this output with respect to a biasing voltage level of the differential amplifier. In accordance with another aspect of the present invention, a symmetric square wave signal is supplied using an amplifier having a differential pair paired configuration, with a symmetric square wave signal being supplied as the voltage differential between paired outputs of the differential amplifier. The differential pair configuration improves design symmetry of the amplifier, which is particularly valuable for providing oscillating signals of frequency above 800 MHz.

In accordance with another aspect of the present invention, an oscillating input signal is processed to generate an output signal which is fed back and differentially amplified with the input signal. More particularly, the output signal is filtered to substantially attenuate frequencies components thereof of frequency at least as high as the fundamental frequency of oscillation of the input signal. The amplitude differential between the input signal and the filtered output signal is then amplified to supply the output signal. This attenuates any D.C. component in the output signal. Preferably, some frequency components of the output signal below the fundamental frequency of oscillation of the input signal are amplified together with such filtration process to further attenuate any D.C. component in the output signal. Amplification of such amplitude differential may include clipping the amplitude differential at both maximum and minimum amplitudes to supply the output signal. This supplies an output signal with a substantially symmetric square wave profile by attenuating both the D.C. component and even order harmonic components.

Oscillating signals supplied in accordance with the present invention yield various benefits in frequency shifting applications. For example, in a mixer circuit the absence of D.C. and second order harmonic components in such oscillating signal significantly reduces the amount of signal power from unwanted interfering signals that is frequency translated into the intermediate frequency band of the desired signal. Further, undesired mixing products generated by odd order harmonics, other than at the primary frequency of oscillation, typically will not overlap signals desired from the frequency shifting operation, and can be filtered off. Moreover, some common mixer designs, such as the Gilbert Cell mixer, yield minimal noise when a square wave signal is used as an input signal, and the symmetric square wave signals supplied in accordance with the present invention are thus ideal for use with such mixers. Finally, the symmetric square wave signals have a fifty percent duty cycle, which may prove valuable for supplying high quality clocking signals on high frequency integrated circuit chips.

## BRIEF DESCRIPTION OF THE DRAWINGS

Figure 1 is a block diagram showing a conventional circuit for downshifting an input signal IN to obtain a desired signal and undesired mixing products.

Figure 2A is a block diagram of a first embodiment of an improved system for supplying oscillating signals having suppressed even order harmonic components, and for using such oscillating signals for downshifting an input signal IN to obtain a desired signal DS, in accordance with the present invention.

Figure 2B is a timing diagram illustrating a first embodiment of operation of the improved system of Figure 2A in accordance with the present invention.

Figure 2C is a flow diagram illustrating a first embodiment of operation of the improved system of Figure 2A in accordance with the present invention.

Figure 2D is a block diagram of an embodiment of a low-pass filter for use in the improved system of the present invention shown in Figure 2A.

Figure 3A is a block diagram of a second embodiment of an improved system of the present invention for supplying oscillating signals having suppressed even order harmonic components, with the oscillating signals being supplied differentially across paired outputs, in accordance with the present invention.

Figure 3B is a block diagram of a third embodiment an improved system for supplying oscillating signals having suppress harmonic content, and for driving a mixer with such oscillating signals to downshift an input signal IN, in accordance with the present invention.

Figure 3C is a block diagram of an alternative embodiment an improved system for supplying oscillating signals having suppress harmonic content, and for driving a mixer with such oscillating signals to downshift an input signal IN, in accordance with the present invention.

## DETAILED DESCRIPTION OF THE INVENTION

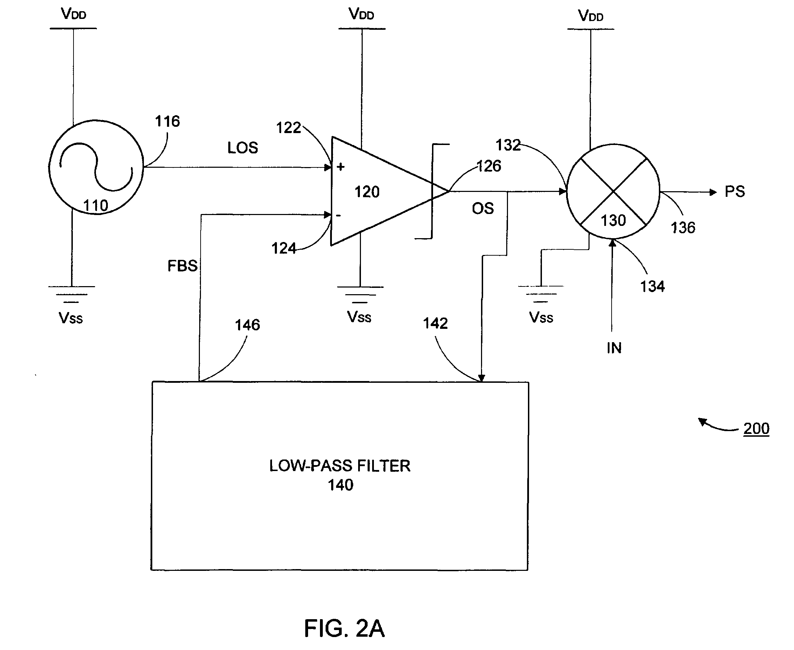

Referring now to Figures 2A there is shown a block diagram of a first embodiment an improved system 200 of the present invention for supplying oscillating signals having suppressed even order harmonic components, and for using such oscillating signals to downshift an input signal (IN) to obtain a desired signal (DS). Improved system 200 comprises a local oscillator 110, a differential amplifier 120, a mixer 130, and a low-pass filter 140. The local oscillator 110 has an output 116. The differential amplifier 120 has a non-inverting input 122, an inverting input 124, and an output 126. The mixer 130 has first and second inputs 132, 134 and an output 136. Finally, the low-pass filter 140 has an input 142 and an output 146.

The local oscillator 110, differential amplifier 120, mixer 130, and low-pass filter 140 are coupled to a power supply at $V_{DD}$, an electrical ground at $V_{SS}$, and one another as follows. The non-inverting input 122 of the differential amplifier 120 is coupled to the output 116 of the local oscillator 110. The output 126 of the differential amplifier 120 is coupled to both the first input 132 of the mixer 130 and the input 142 of the low-pass filter 140. Finally, the output 146 of the low-pass filter 140 is coupled to the inverting input 124 of the differential amplifier 120.

The local oscillator 110 supplies local oscillator signal LOS at output 116. The local oscillator signal LOS has a fundamental frequency $f_{LOS}$ of approximately 800 MHz and magnitude of approximately 200 mV peak-to-peak. The local oscillator signal LOS may also include various distortion components, such as a direct current (D.C.) component and harmonic components.

The differential amplifier 120 supplies an output signal OS at output 126. The output signal OS is an amplification of the voltage differential ($V_{122}$ - $V_{124}$) between the non-inverting and inverting input ports 122, 124. The differential amplifier 120 is designed to clip at minimum and maximum clipping voltages $V_{MIN}$, $V_{MAX}$ respectively during normal operation. These clipping voltages $V_{MIN}$, $V_{MAX}$ respectively are minimum and maximum sustainable voltage levels which can be supplied by the differential amplifier 120. As is understood by those skilled in the art, the differential amplifier 120 may briefly supply voltages less than the minimum clipping voltage $V_{MIN}$ and greater than the maximum clipping voltage $V_{MAX}$. The gain $\tau$ and slew rate $\gamma$ of the differential amplifier 120 should preferably be sufficiently high that the differential amplifier 120 clips very quickly. That is, a voltage differential between inputs 122, 124 which exceeds 5 mV to 6 mV should cause the differential amplifier 120 to clip. To this end, the magnitude of the gain $\tau$ should be greater than twelve, and the slew rate $\gamma$ should be at least $1/(4 \times f_{LOS})$. Because the differential amplifier 120 clips during normal operation, the gain $\tau$ is extremely non-linear. The following exemplary voltage levels may be used, $V_{DD}$ = +2.5 V, $V_{SS}$ = -2.5 V, $V_{MAX}$ = 100 mV, and $V_{MIN}$ = -100 mV.

In improved system 200, the low-pass filter 140 preferably has a 3db frequency of about 10 kHz. The magnitude of the transfer function $H(\omega)$ of the low-pass filter 140 should be substantially greater than one for frequencies $\omega \cong 0$, i.e. at and near D.C. Preferably, this magnitude | H(0) | should be at least forty. Further, in this embodiment of the present invention, H(0) should have positive amplitude. The low-pass filter 140 should strongly attenuate signals of frequency $2\pi\omega$ at or above $f_{LOS}$. However, even a signal pole filter typically suffices here because $f_{LOS}$ is many orders of magnitude higher in frequency than the specified 3dB frequency.

The mixer 130 comprises a conventional Gilbert Cell mixer. The mixer 130 includes a plurality of pass transistors which received signals. In particular, an oscillating signal supplied to input 132 drives the pass transistors at variable rate. The transistors are coupled to amplify a second signal received at input 134 at the rate determined by the oscillating signal. This multiplies the second signal by the oscillating signal, with the product being supplied as a voltage level at output 136.

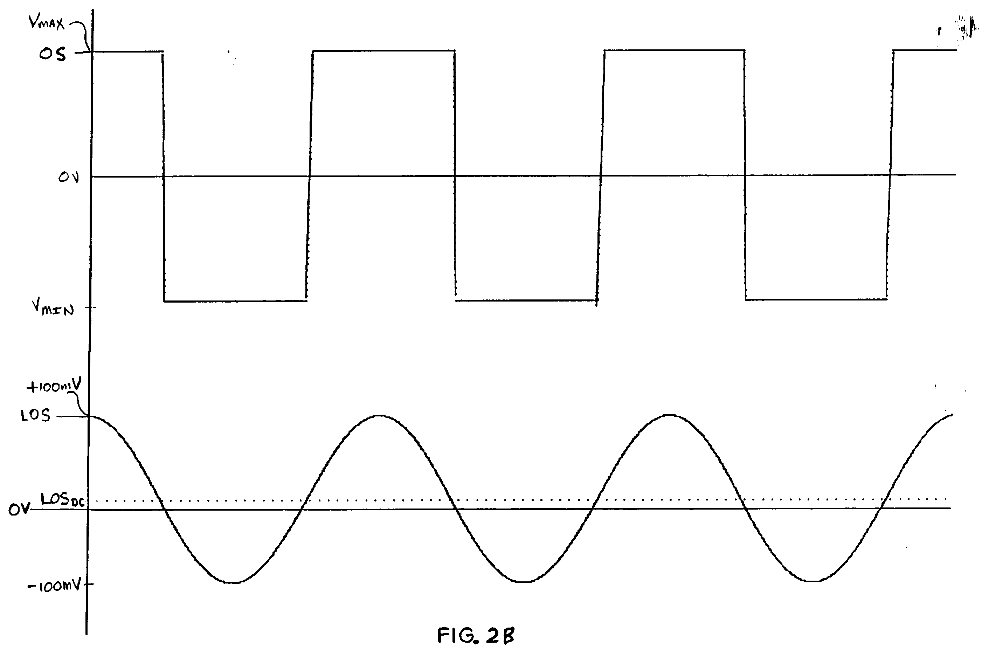

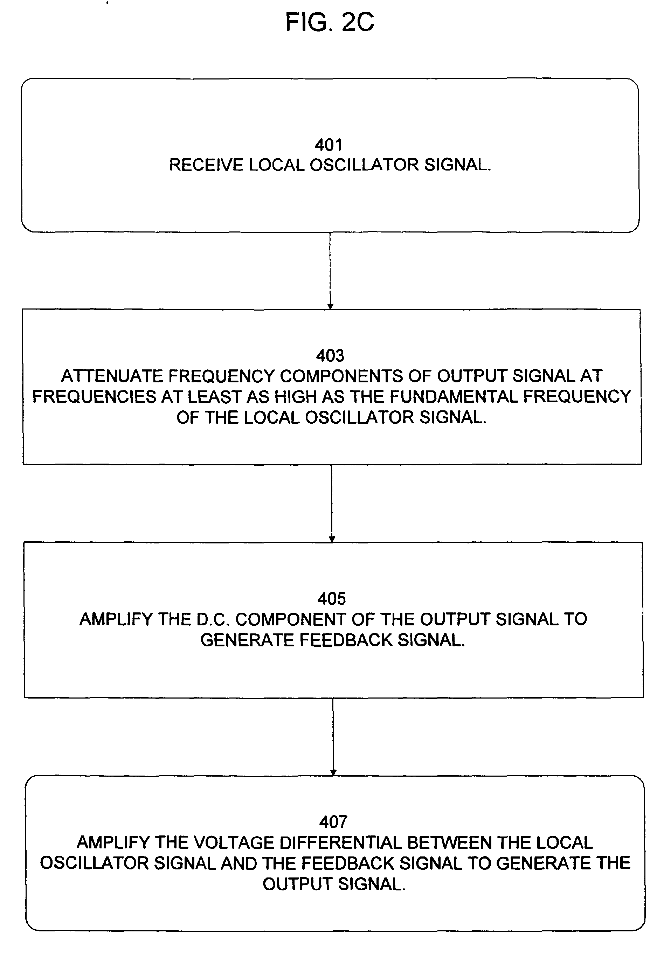

Referring now to Figures 2B and 2C there are respectively shown timing and flow diagrams illustrating operation of improved system 200. In operation, the non-inverting input 122 receives 401 the local oscillator signal LOS from the local oscillator 110. The inverting input 124 receives a feedback signal FBS from a feedback loop. The feedback loop traverses a path from the output 126 of the differential amplifier 120, through the low-pass filter 140 to the inverting input 124 of the differential amplifier 120, and through the differential amplifier 120 back to the output 126 of the differential amplifier 120. The feedback signal FBS is an amplification of the D.C. component of the output signal OS supplied by the differential amplifier 120. Frequency components of the output signal OS at frequencies at least as high as $f_{LOS}$ are substantially attenuated 403 by the low-pass filter 140. The D.C. component of the output signal OS is amplified 405 by $H(0) \cong 40$ in the low-pass filter 140.

The differential amplifier 120 amplifies 407 the voltage differential (LOS - FBS) between its non-inverting and inverting inputs 122, 124, with the output signal OS of the differential amplifier 120 being this amplified voltage differential. By operation of the feedback loop, any D.C. component $LOS_{DC}$ in the local oscillator signal LOS is suppressed at output 126 by a factor of approximately $1/H(0)$. That is, substantially no D.C. will be introduced to the output signal OS by such D.C. component $LOS_{DC}$. Consequently, the output signal OS will be near $V_{MIN}$ for the same amount of time that it is near $V_{MAX}$, and will thus closely approximate a symmetric square wave having frequency $f_{LOS}$.

Improved system 200 is substantially immune to variations in the amplitude of the local oscillator signal LOS. If the amplitude of the local oscillator signal LOS increases, the output signal OS might transition slightly faster between the minimum and maximum clipping voltages $V_{MIN}$, $V_{MAX}$. However, by design these transition times are always very short. Consequently, even if the quality of the local oscillator signal LOS becomes degraded, the output signal OS will still closely approximate a symmetric square wave.

Improved system 200 substantially eliminates any D.C. component introduced to the output signal OS by the differential amplifier 120. Such D.C. component would be tracked by the feedback signal FSB and suppressed. For example, if the D.C. component of the output signal OS increases from 0 V, then the voltage of feedback signal FBS will increase, which increases the voltage at the inverting input 124 of the differential amplifier 120, which causes the voltage of the output signal OS to decrease back toward 0 V. Similarly, if the D.C. component of the output signal OS decreases below 0 V, then the voltage of feedback signal FBS will decrease, which decreases the voltage at the inverting input 124 of the differential amplifier 120, which causes the voltage of the output signal OS to increase back toward 0 V. Thus, the feedback loop accounts for non-idealities both in the differential amplifier 120 and in the local oscillator 110. These properties are particularly beneficial for supplying square wave signals having essentially no D.C. and even order harmonic components, and thus for suppressing undesired signals in a receiver.

Because the output signal OS provided by improved system 200 closely approximates a symmetric square wave, it will have even order harmonic components which are all very close to zero. That is, the D.C., 2nd, 4th, 6th,..., nth (where n is an even integer) order harmonic components of the output signal OS typically are all very close to zero amplitude. This can be seen from the coefficients for a harmonic Fourier series representation of a symmetric square wave, which are given as:

$$a_0 = D.C. \text{ component } 0; \text{ and}$$

$$a_k = 4/M \times [\sin(k\pi/2)/(k\pi/2)], \text{ for } k \geq 1;$$

where k is the order of the harmonic term. The harmonic Fourier series representation for output signal OS is given as:

$$OS \cong a_0 + a_1 \times \cos(\omega_1 t) + a_2 \times \cos(2\omega_1 t) + a_3 \times \cos(3\omega_1 t) + ... ;$$

where t represents time and $\omega_1 = f_{LOS}/2\pi$. From the coefficient equation above it can be immediately seen that the even order coefficients $a_{2n} = \sin(n\pi) = 0$. Thus, all of the even order harmonic components in the output signal OS are substantially suppressed by operation of improved system 200.

The output signal OS from the differential amplifier 120 is beneficially used by the mixer 130 for downshifting the input signal IN to obtain desired signal DS in an intermediate frequency $f_{IF}$ band. The first input 132 of the mixer 130 receives the output signal OS of the differential amplifier 120, and the second input 134 of the mixer 130 receives the input signal IN. The mixer 130 downshifts the input signal IN to supply a product signal PS at output 136. The product signal PS is the superposition (sum) of the desired signal DS and a minimal quantity of undesired mixing products.

Note that the output signal OS has substantially no D.C. and second harmonic content. Thus, when the output signal OS of the differential amplifier 120 is mixed with the input signal IN in the mixer 130, the closest non-zero harmonic component of the output signal OS which can generate undesired mixing products is the third order harmonic component. The undesired mixing products caused by third order harmonics typically will not overlap with the spectrum of the desired signal DS because third order harmonics are too far away in the frequency domain. The product signal PS can thus be band-pass filtered to remove the undesired mixing products, and yield the desired signal DS substantially undistorted by the downshifting operation. Note that the amplitude of third order harmonics of a symmetric square wave is less than one third that of the fundamental frequency component. Production of undesired mixing products by the third order harmonics thus do not significantly absorb system power.

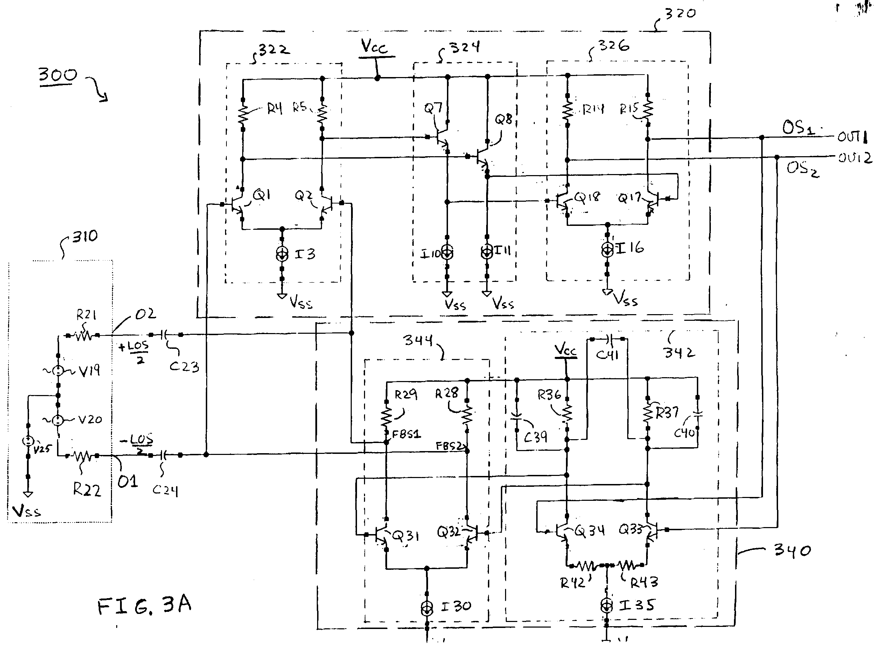

Various modifications to improved system 200 are also in accordance with the present invention. For example, in improved system 200, the non-inverting input 122 of the differential amplifier 120 receives the local oscillator signal LOS and the inverting input 124 receives the feedback signal FSB. However, in alternative embodiments of the present invention, the inverting input 124 receives the local oscillator signal LOS and the non-inverting input 122 receives the feedback signal FSB. Operation of such an alternative embodiment of the present invention is similar to that of improved system 200, except that the output signal OS is inverted. In another alternative embodiment of the present invention, band-pass filters are included at one or both inputs of the mixer to further reduce generation of undesired mixing products. In other alternative embodiments of the present invention, a differential amplifier is used which has either two inverting or two non-inverting input ports. This can be accomplished, for example, by modifying the low-pass filter 140 so that it inverts the feedback signal FBS. Alternatively, the differential amplifier or low-pass filter can have differential pair configuration. An embodiment of the present invention having such latter feature is disclosed more fully below with respect to Figure 3A.

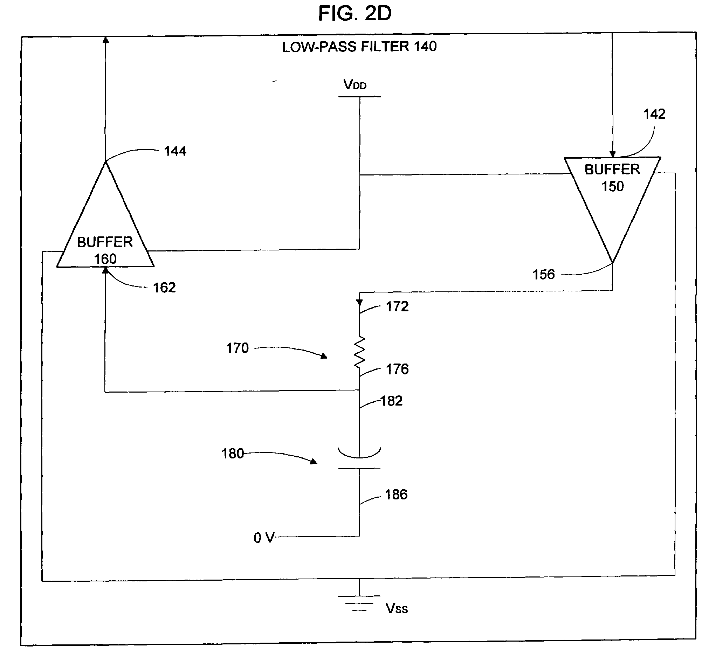

Referring now also to Figure 2D, there is shown an embodiment of low-pass filter 140 which includes first and second buffers 150, 160, a resistor 170 of resistance R, and a capacitor 180 of capacitance C. The first buffer 150 has an input 142, which serves as the input 142 of the low-pass filter 140, and an output 156. The second buffer 160 has an input 162, and has an output 144 which serves as the output 144 of the low-pass filter 140. The resistor 170 has ends 172, 176, and the capacitor 180 has plates 182, 186.

Low-pass filter 140 is coupled together as follows. The output 156 of the first buffer 150 is coupled to end 172 of resistor 170. End 176 of resistor 170 is coupled to both the input 162 of the second buffer 160 and to plate 182 of capacitor 180, Plate 186 of the capacitor 180 is coupled to a 0 V source. Finally, both buffers 150, 160 are coupled to the power supply $V_{DD}$ and to ground $V_{SS}$. Thus, in conventional manner, the voltage differential across the plates 182, 186 of the capacitor 180 acts as a low-pass filter. The resistance R and capacitance C are selected to provide a 3dB cutoff frequency of about 10kHz. This is achieved if the time constant $t = C \times R \cong (1/20k\pi)$ seconds.

In operation, the input 142 of first buffer receives the output signal OS from output 126 of the differential amplifier 120. The first buffer 150 prevents the resistor 170 and capacitor 180 from loading the output 126 of the differential amplifier 120. The first buffer 150 also supplies an amplified output signal to the resistor 170. The amplified output signal is then filtered by the resistor 170 and capacitor 180, with a filtered and amplified signal being supplied at plate 182. This filtering is passive and hence provides no additional gain. The filtered and amplified output signal is supplied to the second buffer 160, which amplifies it to supply the feedback signal FSB at output 144. The feedback signal FSB is substantially a D.C. signal due to the filtering effect of the resistor 170 and capacitor 180. Preferably, the gains of buffers 150 and 160 are two and twenty respectively.

Referring now to Figure 3A there is shown a circuit schematic of a second embodiment of an improved system 300 of the present invention for supplying oscillating signals having suppressed even order harmonic components. Improved system 300 comprises a local oscillator 310, a differential amplifier 320, a low-pass filter 340, and capacitors C23, C24, and uses a power supply $V_{CC} = 2.7$ V, and ground $V_{SS} = 0$ V. The differential amplifier 320 and low-pass filter 340 each have differential pair configurations. Except as noted below, the improved system 300 is preferably implemented on a single integrated circuit chip using bipolar technology. It is noted that, for ease of understanding, like reference characters have been used for like items where possible.

The local oscillator 310 includes a fixed voltage source V25, oscillating voltage sources V19, V20, and impedances R21, R22. Oscillating voltage sources V19, V20 are serially coupled together, and are further respectively coupled through respective impedances R21, R22 to form respective outputs O2, O1 of the local oscillator 310. Fixed voltage source V25 is coupled to oscillating voltage sources V19, V20 and ground $V_{SS}$ to bias the average voltage at outputs O2, O1 to about ½ $V_{CC}$. A local oscillator signal (LOS) is thus supplied in conventional manner as the voltage differential between outputs O2, O1, with the local oscillator signal LOS being the voltage at output O2 minus the voltage at output O1. The local oscillator signal LOS preferably has a fundamental frequency of 2 GHz and magnitude of 200 mV peak-to-peak, but may also include various distortion components of significantly lower magnitude. Note that due to capacitors C23, C24, the local oscillator 310 does not need to be impedance matched with the differential amplifier 320 and low-pass filter 340, and thus impedances R21, R22 can each have a broad range of impedance values, or alternatively, can be parasitic impedances.

The differential amplifier 320 includes soft limiting amplifiers 322, 326, and a unity gain buffer 324. Soft limiting amplifier 322 includes resistors R4, R5, npn bipolar transistors Q1, Q2, and a constant current source I3. The power supply $V_{CC}$ is coupled by resistor R4 to the collector of transistor Q1, and the emitter of transistor Q1 is coupled by the constant current source I3 to ground $V_{SS}$. Similarly, the power supply $V_{CC}$ is coupled by resistor R5 to the collector of transistor Q2, and the emitter of transistor Q2 is coupled by the constant current source I3 to ground $V_{SS}$. A differential

6

amplification of the voltages on the respective bases of transistors Q1, Q2 is thus supplied in conventional manner between the collectors of transistors Q1 and Q2.

The unity gain buffer 324 includes npn bipolar transistors Q7, Q8 and constant current sources I10, I11, and is coupled to supply a substantially constant D.C. down-shift of the voltage levels of the collectors of transistors Q2, Q1 of soft limiting amplifier 322, as follows. The base of transistor Q7 is coupled to the collector of transistor Q2 of soft limiting amplifier 322, the collector of transistor Q7 is coupled to the power supply $V_{CC}$, and the emitter of transistor Q7 is coupled by the constant current source I10 to ground $V_{SS}$. Transistor Q7 thus buffers the voltage from the collector of transistor Q2 of soft limiting amplifier 322 in a conventional manner, and the voltage at the emitter of transistor Q7 will be down-shifted by about 0.7 V relative to the voltage at the collector of transistor Q2, with such down-shift being the diode voltage drop from base to emitter in transistor Q7. Similarly, the base of transistor Q8 is coupled to the collector of transistor Q1 of soft limiting amplifier 322, the collector of transistor Q8 is coupled to the power supply $V_{CC}$, and the emitter of transistor Q8 is coupled by the constant current source I11 to ground $V_{SS}$. Transistor Q8 thus buffers the voltage from the collector of transistor Q1 in conventional manner, and the voltage at the emitter of transistor Q8 will be down-shifted by about 0.7 V relative to the voltage at the collector of transistor Q1, with such down-shift being the diode voltage drop from base to emitter in transistor Q8. These diode voltage drops bias transistors Q17, Q18 of soft limiting amplifier 326 to prevent them from entering saturation.

Soft limiting amplifier 326 includes resistors R14, R15, npn bipolar transistors Q18, Q17, and constant current source I16, which are coupled together in substantially the same manner as in soft limiting amplifier 322. Soft limiting amplifier 326 is substantially similar to soft limiting amplifier 322 except that transconductance and resistance values are modified in soft limiting amplifier 326 and match the diode voltage drop supplied by the unity gain buffer 324. The base of transistor Q18 is coupled to the emitter of transistor Q7 of unity gain buffer 324, and the base of transistor Q17 is coupled to the emitter of transistor Q8 of unity gain buffer 324. The collectors of transistors Q18, Q17 thus supply a differential amplification of the voltages from the emitters of transistors Q7, Q8 respectively. The collectors of transistors Q18, Q17 respectively form outputs OUT2, OUT1 of the differential amplifier 320.

Soft limiting amplifiers 322, 326 and unity gain buffer 324 have symmetrical designs. This symmetry preferably is enhanced by closely matching transistors and resistors within each of the soft limiting amplifiers 322, 326, and the unity gain buffer 324. Such symmetry prevents soft limiting amplifier 322 from favoring either positive or negative input voltage differentials between the bases of transistors Q1, Q2. Consequently, the gain of soft limiting amplifier 322 will not depend on the sign of such voltage differential. The unity gain buffer 324 and soft limiting amplifier 326 will be similarly improved by such symmetry. The differential amplifier 320 thus comprises a highly symmetric three stage differential amplifier which receives input signals at the bases of transistors Q1, Q2 of soft limiting amplifier 322, and supplies output signals corresponding thereto at the collectors of transistors Q17, Q18, respectively. Using three stages assures that the differential amplifier 320 will quickly clip between minimum and maximum clipping voltages $V_{MIN}$, $V_{MAX}$ if the input signals have a voltage differential of about 5 mV to 6 mV.

The low-pass filter 340 includes an amplifying loop filter 342 and a second stage amplifier 344. The amplifying loop filter 342 includes capacitors C39, C40, optional off-chip capacitor C41, resistors R36, R37, npn bipolar transistors Q34, Q33, and a constant current source I35. Capacitor 39 and resistor R36 are coupled in parallel to the power supply at $V_{CC}$ and the collector of transistor Q34. The emitter of transistor Q34 is serially coupled by resistor R42 and constant current source I35 to ground $V_{SS}$. Similarly, capacitor 40 and resistor R37 are coupled in parallel to the power supply $V_{CC}$ and the collector of transistor Q33, and the emitter of transistor Q33 is serially coupled by resistor R43 and constant current source I35 to ground $V_{SS}$. A differential amplification and low-pass filtering of the voltages on the bases of transistors Q34 and Q33 is thus supplied in conventional manner between the collectors of these transistors Q34 and Q33. In particular, the collectors of transistors Q34, Q33 supply current at levels responsive to the voltage levels on their respective bases. These currents drive the parallel combinations of capacitors C39, C40 and resistors R36, R37. This achieves a current driven low-pass filtering of the voltage signals on the bases of transistors Q34, Q33, with the output signal of the low-pass filtering being the voltage differential between the collectors of transistors Q34 and Q33. This low pass filtering includes amplification by respective gains approximately given by the ratios R36/R42 and R37/R43 of resistances, with both such ratios preferably being about equal to two. Note that resistors R42, R43 maintain transistors Q34, Q33 in linear regions of operation and thus prevents clipping in the low-pass filter 340. As is understood in the art, the voltage on the collectors will also include a substantially constant biasing voltage needed to make the transistors Q34, Q33 operate. The optional off-chip capacitor C41 can be coupled between the collectors of transistors Q34, Q33 for increased stability.

The second stage amplifier 344 includes resistors R29, R28, npn bipolar transistors Q31, Q32, and a constant current source I30, and is coupled together in substantially the same manner as soft limiting amplifiers 322, 326. The base of transistor Q31 is coupled to the collector of transistor Q34 of amplifying loop filter 342, and the base of transistor Q32 is coupled to the collector of transistor Q33 of amplifying loop filter 342. In conventional manner, the collectors of transistors Q31, Q32 thus supply an amplification of the voltages from the collectors of transistors Q34, Q33 of amplifying loop filter 342. The total gain supplied to D.C. signals by combined operation of the amplifying loop filter 342 and second stage amplifier 344 should be about forty to assure appropriate attenuation of D.C. voltage components in the differential amplifier 320.

The local oscillator 310, differential amplifier 320, low-pass filter 340, and capacitors C23, C24 are coupled together as follows. Output O2 of the local oscillator 310 is coupled by capacitor C23 to the base of transistor Q2 of the soft limiting amplifier 322, and output O1 of the local oscillator 310 is coupled by capacitor C24 to the base of transistor Q1 of the soft limiting amplifier 322. The collector of transistor Q18 of the differential amplifier 320 is coupled to the base of transistor Q33 of the low-pass filter 340, and the collector of transistor Q17 of the differential amplifier 320 is coupled to the base of transistor Q34 of the low-pass filter 340. Finally, the collector of transistor Q31 of the low-pass filter 340 is coupled to the base of transistor Q2 of the differential amplifier 320, and the collector of transistor Q32 of the low-pass filter 340 is coupled to the base of transistor Q1 of the differential amplifier 320. It is noted that the feedback loop traverses a path from output OUT2 via transistors Q33, Q32, Q1, Q8, Q17 to output OUT1, and therefrom via transistors Q34, Q31, Q2, Q7, Q18 back to output OUT2.

Improved system 300 operates as follows. The local oscillator 310 supplies the alternating current (A.C.) portion of the local oscillator signal LOS between the bases of transistors Q2, Q1. Any D.C. components in the local oscillator signal LOS are attenuated by capacitors C23, C24. The differential amplifier 320 amplifies the voltage on the bases of transistors Q2, Q1 and supplies corresponding output signals $OS_2$, $OS_1$ at the collectors of transistors Q18, Q17 respectively, with supplied voltage differential ($OS_2 - OS_1$) being an amplification of the A.C. portion of the local oscillator signal LOS. The differential amplifier 320 clips very quickly between minimum and maximum clipping voltages $V_{MIN}$, $V_{MAX}$. Thus, when driven with local oscillator signal LOS, the supplied voltage differential ($OS_2 - OS_1$) will be a square wave.

The differential amplifier 320 supplies the output signals $OS_2$, $OS_1$ to the low-pass filter 340. In particular, output signal $OS_2$ is supplied to the base of transistor Q33 and output signal $OS_1$ is supplied to the base of transistor Q34. In response to the received output signals $OS_2$, $OS_1$, the low-pass filter 340 supplies corresponding feedback signals $FBS_2$, $FBS_1$. Feedback signal $FBS_2$ is supplied at the collector of transistor Q32, and is an amplification of the D.C. component of output signal $OS_2$. Similarly, feedback signal $FBS_1$ is supplied at the collector of transistor Q31, and is an amplification of the D.C. component of output signal $OS_1$. The voltage differential ($FBS_2 - FBS_1$) is thus an amplification of the D.C. component of voltage differential ($OS_2 - OS_1$).

The low-pass filter 340 supplies the feedback signal $FBS_2$, $FBS_1$ to the differential amplifier 320. In particular, feedback signal $FBS_2$ is supplied to the base of transistor Q1, and feedback signal $FBS_1$ is supplied to the base of transistor Q2. The D.C. signal components supplied to the bases of transistors Q1, Q2 will substantially be $FBS_2$, $FBS_1$ respectively, and the A.C. component supplied to the bases of transistors Q1, Q2 will substantially be the A.C. components of the voltages at outputs O1, O2 of the local oscillator 310. Note that capacitors C24, C23 can be safely omitted. If capacitors C24, C23 are omitted, the D.C. components in the local oscillator signal LOS will be received at the bases of transistors Q2, Q1 and will be suppressed by operation of the feedback loop. Preferably, the capacitors C24, C23 are included as shown to further suppress the D.C. components of the local oscillator signal LOS.

The feedback signals $FBS_1$, $FBS_2$ attenuate the D.C. component of the voltage differential ($OS_2 - OS_1$). For example, if the D.C. component of this voltage differential ($OS_2 - OS_1$) increases from 0 V, then the voltage of feedback signal $FBS_2$ will increase relative to feedback signal $FBS_1$, which increases the D.C. component of the voltage at the base of transistor Q1 relative to the base of transistor Q2, which causes the D.C. component of voltage differential ($OS_2 - OS_1$) to decrease back toward 0 V. Similarly, if the D.C. component of the voltage differential ($OS_2 - OS_1$) decreases from 0 V, then the voltage of feedback signal $FBS_2$ will decrease relative to feedback signal $FBS_1$, and thus the D.C. component of voltage differential ($OS_2 - OS_1$) will increase back toward 0 V.

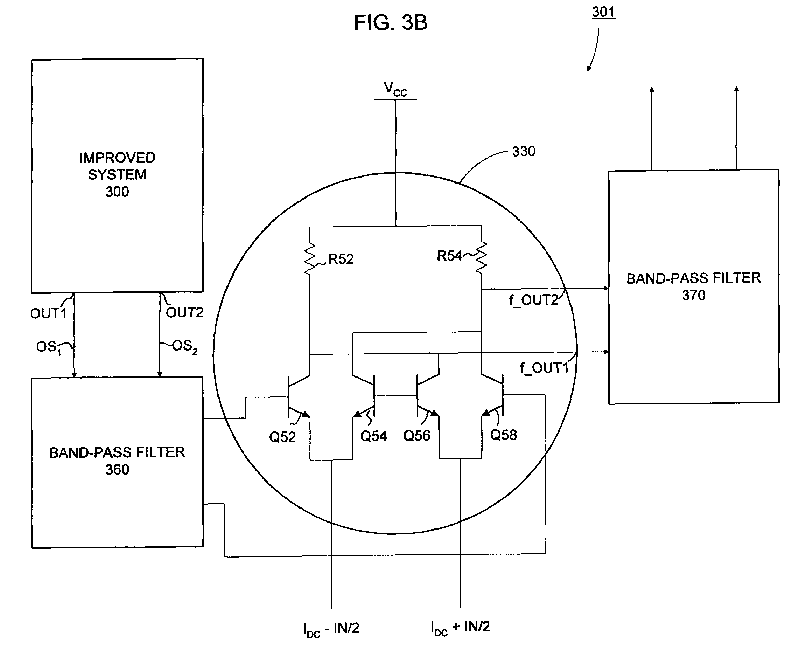

Referring now to Figure 3B, there is shown a third embodiment of an improved system 301 of the present invention wherein improved system 300 is further coupled for downshifting an input signal IN to obtain a desired signal DS. Improved system 301 includes improved system 300, band-pass filters 360, 370, and a mixer 330.

Band-pass filter 360 has differentially paired inputs and outputs, and is preferably implemented in conventional manner as a tuned circuit of inductors, capacitors, and resistors. Input signals are supplied differentially at the paired inputs. Band-pass filter 360 attenuates frequencies of the voltages on the paired inputs except in a narrow pass-band around 2 GHz. The band-pass filter supplies the filtered voltages as paired output signals. Band-pass filter 370 has differentially paired inputs and outputs, and preferably is a conventional surface acoustic wave (SAW) filter, or alternatively a conventional crystal filter. Bandpass filter 360 attenuates frequencies except in a narrow pass-band around an intermediate frequency $f_{IF}$ of about 85 MHz.

The mixer 330 includes resistors R52, R54, and npn bipolar transistors Q52, Q54, Q56, and Q58. The power supply $V_{CC}$ is coupled by resistor R54 to the collectors of transistors Q54, Q58, which together form output f_OUT2 of the mixer 330. The power supply $V_{CC}$ is further coupled by resistor R52 to the collectors of transistors Q52, Q56, which together form output f_OUT1 of mixer 330. The emitters of transistors Q56, Q58 are coupled together to form input IN2 of the mixer 330, and the emitters of transistor Q52, Q54 are coupled together to form input IN1 of the mixer 330. The inputs each draw substantially constant direct current $I_{DC}$ of amplitude 1 mA from the mixer 330 to power the transistors Q52, Q54, Q56, Q58. An input small signal IN may be supplied between the inputs IN2 and IN1. In this embodiment of the present invention, the input small signal IN is a current signal, and is superimposed on the $I_{DC}$ direct currents. The mixer 330 is driven by an oscillating signal received between the bases of transistor Q52 and Q58. The oscillating signal controls instantaneous amplification provided by the transistors Q52, Q54, Q56, Q58 to the input small signal IN.

Improved system 301 is coupled together as follows. Outputs OUT2, OUT1 of improved system 300 are coupled to band-pass filter 360. Band-pass filter 360 is coupled to the bases of transistors Q52, Q58 of the mixer 330, and outputs f_OUT2, f_OUT1 of the mixer 300 are coupled to band-pass filter 370. The paired outputs of band-pass filter 370 form the outputs of improved system 301.

In operation, improved system 300 supplies a symmetric square wave signal of frequency $f_{LOS}$ to band-pass filter 360. Band-pass filter 360 suppresses essentially all but the fundamental frequency component at 2 GHz. These are primarily the odd order harmonic components, i.e. the $3^{rd}$, $5^{th}$, $7^{th}$, $9^{th}$..., $m^{th}$ (where m is an odd integer) order harmonic components, because the even order harmonic components have already been substantially suppressed by improved system 300. However, any even order harmonic content that was not suppressed by improved system 300 will be substantially attenuated in band-pass filter 360. Hence, the mixer 330 receives an essentially pure sinusoidal signal of frequency 2 GHz. This beneficially reduces production of undesired mixing products in the mixer 300. The essentially pure sinusoidal signal drives the mixer 300 to downshift an input signal IN received between the inputs IN2, IN1 of the mixer 330. The mixer 330 supplies a downshifted product signal PS between outputs f_OUT2 and f_OUT1. The product signal PS contains essentially no undesired mixing products because the mixer 330 is driven by an essentially pure sinusoidal signal. The product signal PS will lie almost entirely in an intermediate frequency $f_{IF}$ band determined by the frequency $f_{LOS}$ of the symmetric square wave signal and the frequency band of the input small signal IN. Preferably, $f_{LOS}$ is about 2 GHZ and the intermediate frequency $f_{IF}$ is about 85 MHz for application to downshifting cellular telephone signals to perform filtering and or amplification processes in the intermediate frequency $f_{IF}$ band. Any undesired mixing products that might be generated lie almost entirely out of the intermediate frequency $f_{IF}$ band, and are easily filtered off by band-pass filter 370. The improved system 300 thus supplies very high quality downshifting of input small signals, as desired. It is noted that improved systems 300 and 301 can alternatively can achieve frequency shifting to substantially any frequency band by varying $f_{LOS}$.

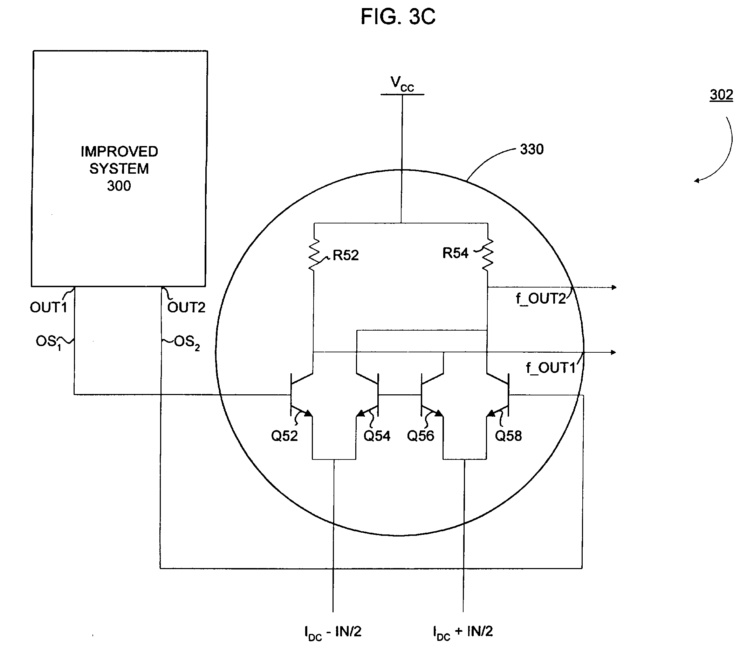

It is further noted that band-pass filters 360, 370 are optional, and are included in improved system 301 for increased suppression of harmonics. Alternatively, either band-pass filter 360, 370 may be omitted, for example, by coupling outputs OUT2, OUT1 respectively to the base of transistor Q58, Q52, and by accepting signals output by the mixer 330 as a representation of the desired downshifted signal. This may be preferable to achieve lower noise in some conventional Gilbert cell mixer designs. An embodiment of such an improved system 302 is shown in Figure 3C.

The above description and accompanying figures are included to disclose the structure and operation of various preferred embodiments of the present invention and are not meant to limit the scope of the present invention. From the above description and accompanying figures, many variations to the present invention will be apparent to those skilled in the relevant art. Such variations are encompassed by the present invention, which is limited only by the following claims.

## Claims

1.    A method to supply an output signal, said method using an input signal having a fundamental frequency of oscillation, said method comprising the steps of:

filtering the output signal to substantially attenuate frequency components thereof of frequency least as high as the fundamental frequency of oscillation of the input signal; and

amplifying an amplitude differential between the input signal and the filtered output signal to supply the output signal.

2.    The method of claim 1, wherein a cutoff frequency of said filtering is substantially below the fundamental frequency of oscillation of the input signal.

3.    The method of claim 1 or 2, wherein said filtering has a magnitude response substantially equal to zero for frequencies at least as high as the fundamental frequency of oscillation of the input signal.

4.    The method of one of the preceding claims, wherin the step of filtering includes a D.C. component of the input signal in the filtered output signal for substantially eliminating said D.C. component from the output signal.

5.    The method of one of the preceding claims, wherein the step of filtering the output signal further comprises the sub-steps of:

amplifying frequencies of the output signal below the fundamental frequency of oscillation of the input signal; and

filtering off frequencies of the output signal at least as high as the fundamental frequency of oscillation of the input signal.

6. The method of claim 5, wherein the amplifying sub-step is performed simultaneously with the filtering sub-step.

7. The method of one of the preceding claims, wherein the step of supplying a feedback signal further comprises the sub-steps of:

filtering the output signal to substantially attenuate frequency components thereof of frequency least as high as the fundamental frequency of oscillation of the input signal to supply an intermediate signal; and

amplifying the intermediate signal to supply the filtered output signal.

8. The method of one of the preceding claims, wherein the step of supplying a feedback signal further comprises the sub-steps of:

amplifying the output signal; and

supplying the output signal by filtering the amplified output signal to substantially attenuate frequency components thereof of frequency least as high as the fundamental frequency of oscillation of the input signal.

9. The method of one of the preceding claims, wherein filtering the output signal includes amplifying the output signal.

10. The method of one of the preceding claims, wherein the step of amplifying an amplitude differential between the input signal and the filtered output signal to supply the output signal includes clipping the amplified amplitude differential.

11. The method of one of the preceding claims, wherein the step of amplifying includes clipping the amplified amplitude differential at both maximum and minimum amplitudes to supply the output signal with a substantially symmetric square wave profile.

12. The method of one of the preceding claims, wherein the step of amplifying includes clipping the amplified amplitude differential at both maximum and minimum amplitudes to supply the output signal substantially with both a square wave profile and a fifty percent duty cycle.

13. The method of one of the preceding claims, wherein the step of amplifying includes clipping the amplified amplitude differential both at maximum and minimum amplitudes; and wherein the step of filtering includes a D.C. component of the output signal in the filtered output signal, for attenuating even order harmonic components of the output signal.

14. The method of one of the preceding claims, wherein the step of amplifying includes clipping the amplified amplitude differential both at maximum and minimum amplitudes; and wherein the step of filtering includes an amplification of a D.C. component of the output signal in the filtered output signal, for substantially attenuating even order harmonic components of the output signal.

15. The method of one of the preceding claims, wherein the step of amplifying further comprises the sub-steps of:

receiving first and second signals, with the input signal being the first signal minus the second signal;

receiving third and fourth signals, with the filtered output signal being the third minus the fourth signal;

amplifying the first signal combined with the third signal by a gain factor to supply a fifth signal;

amplifying the second signal combined with the fourth signal by said gain factor to supply a sixth signal, with the output signal being the fifth signal minus the sixth signal; and

filtering both the fifth and sixth signals to attenuate frequency components thereof of frequency at least as high as the fundamental frequency of the input signal; with the third signal being the filtered fifth signal, and the fourth signal being the filtered sixth signal.

16. A system comprising:

a filter coupled to receive an output signal, said filter filtering the output signal to supply a filtered signal comprising at least one frequency component of the output signal; and

an amplifier coupled to receive an input signal and the filtered signal, said amplifier differentially amplifying the input signal and the filtered signal to supply the output signal, for suppressing said at least one frequency component of the output signal.

17. The system of claim 16, wherein the filter comprises a low-pass filter.

18. The system of claim 16 or 17, wherein the filter filters the output signal to supply the filtered signal comprising a D.C. component of the output signal.

19. The system of one of claims 16-18, wherein the filter further comprises:

a second amplifier coupled to receive the output signal, and in response thereto, to supply an amplification of the output signal; and

a low-pass filter coupled to receive the amplification of the output signal, and in response thereto, to supply a D.C. component of said amplification of the output signal as the filtered signal.

20. The system of one of claims 16-18, wherein the filter further comprises:

a low-pass filter coupled to receive the output signal, and in response thereto, to supply a D.C. component of the output signal; and

a second amplifier coupled to receive the output signal, and in response thereto, to supply an amplification of said D.C. component of the output signal as the filtered signal.

21. The system of one of claims 16-20, wherein the amplifier includes an output having a single line which supplies the output signal as a voltage differential with respect to a fixed voltage level.

22. The system of one of claims 16-21, wherein the amplifier includes an output having two lines and supplies the output signal as a voltage differential between said two lines.

23. The system of claim 22, wherein neither of the two lines is at a fixed voltage level with respect to a biasing voltage level.

FIG. 1
(prior art)

FIG. 2A

FIG. 2B

EP 0 954 093 A1

# FIG. 2C

401
RECEIVE LOCAL OSCILLATOR SIGNAL.

403
ATTENUATE FREQUENCY COMPONENTS OF OUTPUT SIGNAL AT
FREQUENCIES AT LEAST AS HIGH AS THE FUNDAMENTAL FREQUENCY
OF THE LOCAL OSCILLATOR SIGNAL.

405
AMPLIFY THE D.C. COMPONENT OF THE OUTPUT SIGNAL TO
GENERATE FEEDBACK SIGNAL.

407
AMPLIFY THE VOLTAGE DIFFERENTIAL BETWEEN THE LOCAL
OSCILLATOR SIGNAL AND THE FEEDBACK SIGNAL TO GENERATE THE
OUTPUT SIGNAL.

FIG. 2D

LOW-PASS FILTER 140

BUFFER 150

BUFFER 160

142

144

150

156

160

162

170

172

176

180

182

186

0 V

$V_{DD}$

$V_{SS}$

FIG. 3A

## FIG. 3B

IMPROVED SYSTEM 300

BAND-PASS FILTER 360

BAND-PASS FILTER 370

$V_{CC}$

330

R52 R54

Q52 Q54 Q56 Q58

f_OUT2

f_OUT1

OUT1 OUT2

$OS_1$ $OS_2$

$I_{DC} - IN/2$ $I_{DC} + IN/2$

301

EP 0 954 093 A1

# FIG. 3C

EP 0 954 093 A1

European Patent
Office

**EUROPEAN SEARCH REPORT**

Application Number

EP 99 10 8277

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 726 646 A (TOKYO SHIBAURA ELECTRIC CO) 14 August 1996 (1996-08-14) * page 1, line 28 - page 7, line 19; figures 4-16 * --- | 1-23 | H03B1/04 H03D7/14 |
| X | US 5 375 258 A (GILLIG STEVEN F) 20 December 1994 (1994-12-20) * column 4, line 16 - column 10, line 18; figures 4-9 * * column 11, line 15 - column 12, line 4; figures 11-13 * --- | 1-23 | |
| A | US 5 179 731 A (TRAENKLE GUENTHER  ET AL) 12 January 1993 (1993-01-12) * column 3, line 3 - line 56; figure 3 * --- | 1-23 | |
| A | US 4 479 259 A (FENK JOSEF) 23 October 1984 (1984-10-23) * column 6, line 58 - column 7, line 5; figure 1 * ----- | 1-23 | TECHNICAL FIELDS SEARCHED (Int.Cl.6) H03B H03D H03K |

The present search report has been drawn up for all claims

| Place of search | Date of completion of the search | Examiner |
|---|---|---|
| THE HAGUE | 23 July 1999 | Dhondt, I |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 99 10 8277

This annex lists the patent family members relating to the patent documents cited in the above-mentioned European search report.
The members are as contained in the European Patent Office EDP file on
The European Patent Office is in no way liable for these particulars which are merely given for the purpose of information.

23-07-1999

| Patent document cited in search report | | Publication date | Patent family member(s) | | Publication date |
|---|---|---|---|---|---|
| EP 0726646 | A | 14-08-1996 | JP | 8223065 A | 30-08-1996 |
| | | | US | 5634207 A | 27-05-1997 |
| US 5375258 | A | 20-12-1994 | CA | 2127271 A,C | 23-06-1994 |
| | | | FR | 2699032 A | 10-06-1994 |
| | | | GB | 2279521 A,B | 04-01-1995 |
| | | | IT | 1262461 B | 19-06-1996 |
| | | | MX | 9307694 A | 31-08-1994 |
| | | | WO | 9414247 A | 23-06-1994 |
| US 5179731 | A | 12-01-1993 | DE | 4018614 A | 13-12-1990 |
| | | | DE | 4018615 A | 13-12-1990 |
| | | | DE | 4018616 A | 13-12-1990 |
| | | | DE | 4018617 A | 13-12-1990 |
| | | | DE | 59009672 D | 26-10-1995 |
| | | | EP | 0401771 A | 12-12-1990 |
| | | | ES | 2079397 T | 16-01-1996 |
| | | | DE | 59007455 D | 17-11-1994 |
| | | | EP | 0448835 A | 02-10-1991 |
| US 4479259 | A | 23-10-1984 | DE | 3041392 A | 13-05-1982 |
| | | | DE | 3045993 A | 08-07-1982 |
| | | | EP | 0051179 A | 12-05-1982 |
| | | | JP | 57106202 A | 02-07-1982 |

EPO FORM P0459

For more details about this annex : see Official Journal of the European Patent Office, No. 12/82